# EUROPEAN PATENT APPLICATION

(11) **EP 2 960 930 A1**
(43) Date of publication of application: **30.12.2015**
(21) Application number: 14753874.8
(22) Date of filing: 24.02.2014
(51) Int. Cl.: H01L 21/60, H01L 21/52

(54) **CONNECTING STRUCTURE, AND SEMICONDUCTOR DEVICE**

(30) Priority: 22.02.2013 JP 2013032791; 29.03.2013 JP 2013073170
(71) Applicant: Furukawa Electric Co., Ltd., Chiyoda-ku Tokyo 100-8322 (JP)
(72) Inventor: SATO, Shunichiro, Tokyo 100-8322 (JP); KOJIMA, Naoyuki, Tokyo 100-8322 (JP); HIKASA, Kazuhito, Tokyo 100-8322 (JP); AMANO, Toshiaki, Tokyo 100-8322 (JP)
(74) Representative: Schäfer, Matthias W.
(86) International application number: PCT/JP2014/054343
(87) International publication number: WO 2014/129626

(57) **Abstract**

An object of the present invention is to provide a connection structure that is able to suppress cracking and peeling in a joint surfaces between a pad part on a substrate (or a lead frame) and a porous metal layer and between a semiconductor element and the porous metal layer. A connection structure (I) for connecting a rear electrode of a semiconductor element to a substrate or a lead frame, wherein a porous metal layer (C) is provided so as to come into contact with at least the rear electrode of the semiconductor element, and the ratio [(B)/(A)] of a porosity of an intermediate portion in the thickness direction of an outer peripheral side part (B) of a region further towards the outside than the cross-section part formed at a position of a distance equivalent to the thickness of the porous metal layer (C) from the side surface toward the inside, to the porosity on the center side (A) after having excluded the outer peripheral side part (B), falls within the range of 1.10 to 1.60.

## Description

### TECHNICAL FIELD

The present invention relates to a connection structure in which a back side metallization of a semiconductor element is joined with a substrate or a lead frame via a porous metal layer, and to a semiconductor apparatus having the connection structure.

The contents of (1) Japan Patent Application No. 2013-032791 filed on February 22 2013 and (2) Japan Patent Application No. 2013-073170 filed on March 29 2013, which are the basic applications of the present application, are incorporated in the present application as reference documents that form a portion of the present specification.

### BACKGROUND ART

Connection structures used in semiconductor apparatuses are manufactured, for example, with a step for forming a die mounting material for joining a semiconductor element (chip) on an element carrying part for a lead frame, a step for mounting the semiconductor element on the front surface of the die mounting material on the lead frame to join the semiconductor element and the element carrying part for the lead frame, a wire bonding step for electrically joining the electrode part of the semiconductor element to the terminal part of the lead frame, and a molding step for covering the semiconductor apparatus assembled in this way with resin.

Patent Document 1 discloses a soldering method involving forming a low melting-point solder layer having a melting point lower than the melting point of the solder material on at least one joint surface side of a material to be joined and the solder material, and then joining the material to be joined and the solder material together at a temperature within a range from the melting point of the low melting-point solder layer to the melting point of the solder material.

Patent Document 2 discloses joining a lead frame having a metal layer on the front surface and a semiconductor element having a metal layer on the rear surface via a joint layer composed of three layers using materials that do not include lead, and joining the metal on any of the adjoining interfaces of the lead frame, the semiconductor element, and the joint layer. Patent Document 3 discloses a metal paste containing a metal powder, an endothermically decomposable metal compound, and a solvent, for bonding via an exothermically densifiable metal paste in order to bond two structural elements.

Patent Document 4 proposes a connection structure in which a metal electrode of a semiconductor element is connected with a die pad via a conductive resin in which are mixed Ag particles (metal particles) that include a noble metal, and a porous nanoparticle coating layer (noble metal layer) in which nanoparticles of Ag (noble metal) are sintered on a metal surface, is formed on at least one mutually opposite surface of the metal electrode or the die pad.

Further, Patent Document 5 proposes a connection structure in which a low-thermal expansion plate is inserted between a semiconductor element and a Cu electrode, and the semiconductor element side is joined by a high-temperature lead-free solder and the Cu electrode side is joined with a porous Ag layer having a porosity of 20 to 70%.

### PRIOR ART DOCUMENT

### Patent Document

Patent Document 1: Japanese Patent Application Publication No. H7-169908A
Patent Document 2: Japanese Patent Application Publication No. 2006-59904A
Patent Document 3: Japanese Patent Application Publication No. 2010-53449A
Patent Document 4: Japanese Patent Application Publication No. 2008-153470A
Patent Document 5: Japanese Patent Application Publication No. 2011-77225A

### DISCLOURE OF THE INVENTION

### Problems to be Solved by the Invention

There is a tendency that the ductility of the solder in the soldering method disclosed in Patent Document 1 is insufficient, and when the joint constituent materials between the constituent materials of the semiconductor element and the circuit wiring substrate mounted on the semiconductor element are different, the reliable lifetime is reduced due to stress distortion during joining caused by phase differences in the thermal expansion coefficients and due to the generation of defects when an impact load is applied. A porous body formed by sintering a conductive paste including metallic fine particles is known as a method for resolving the above problem.

While the joints formed by sintering a metal paste including metallic fine particles disclosed in Patent Documents 2 and 3 are able to prevent breaking due to connection stress by having a low modulus of elasticity due to the porosity to allow for easier deformation, cracking may appear in the vacancies and cracking and peeling may increase in an environment where repetitive heat stress occurs due to heat generation of the semiconductor, and thus a problem may arise with regard to long-term use.

Localized stress generated in the semiconductor element and the joint interface is not alleviated in the connection structure described in Patent Document 4, and defects such as splitting of the semiconductor elements and peeling at the joint interfaces may occur during temperature cycling test (TCT). When the porosity of a layer of sintered metal particles is low, there is a problem that stress applied to the semiconductor element cannot be alleviated and breakage of the semiconductor elements may occur.

The metal bond surface area in the joint interfaces of the connection structure described in Patent Document 5 is reduced and the connection strength during a shear test for evaluating shear force, for example, is also reduced because the porosity of the porous Ag layer is too high. If the porosity is too high, the breaking stress of the material and elongation during high temperatures is reduced whereby there is a problem that the materials in the Ag layer may break more easily and the joint strength is reduced.

An object of the present invention is to provide a connection structure in which a back side metallization of a semiconductor element is joined with a substrate or a lead frame via a porous metal layer, wherein the connection structure is able to improve the connection lifetime and improve connection reliability by suppressing oxidation in the joint parts and suppressing the occurrence of cracking and peeling in the joint surface between the rear electrode of the semiconductor element and the porous metal layer that is the joining member and in the joint surface between the porous metal layer and the substrate or the lead frame, and to provide a semiconductor apparatus having the connection structure.

### Means to Solve the Problem

The inventors of the present invention considered the above conventional art and completed the present invention by finding that the above problems could be resolved in a connection structure in which a back side metallization of a semiconductor element is joined with a substrate or a lead frame via a porous metal layer, by making the porosity of the porous metal layer at an outer peripheral side part of a portion corresponding to the thickness of the metal layer from the side surface, higher at a constant ratio than the porosity of a center side positioned on the inner side excluding the outer peripheral side part,
or by providing a fine copper layer (that is low porous copper layer) and a porous copper layer in the stated order so as to come into contact with the back side metallization of the semiconductor element.

The present invention may be summarized by the invention described in the following points (1) to (14).
(1) A connection structure (I) for connecting a back side metallization of a semiconductor element to a substrate or a lead frame, wherein
   a porous metal layer (C) is provided so as to come into contact with at least the back side metallization of the semiconductor element, and the ratio. [(B)/(A)] of a porosity of an intermediate portion in the thickness direction of an outer peripheral side part (B) of a region further towards the outside than the cross-section part formed at a position of a distance equivalent to the thickness of the porous metal layer (C) from the side surface of the porous metal layer (C) toward the inside, to the porosity on the center side (A) after having excluded the outer peripheral side part (B), falls within the range of 1.10 to 1.60 (hereinafter, also referred to as a first embodiment).
(2) The connection structure (I) as described in (1), wherein the porosity of the center side (A) is from 10.5% to 20.0% in the porous metal layer (C).
(3) The connection structure (I) as described in (1) or (2), wherein the ratio [(B)/(A)] of the modulus of elasticity of a joint layer with the semiconductor element of the outer peripheral side part (B) to the modulus of elasticity of a joint layer with the semiconductor element on the center side (A) is from 0.75 to 0.95 in the porous metal layer (C).
(4) The connection structure (I) as described in any one of (1) to (3), wherein the modulus of elasticity of the joint layer with the semiconductor elements on the center side (A) is from 49.0 GPa to 75.0 GPa in the porous metal layer (C).
(5) The connection structure (I) as described in any one of (1) to (4), wherein the porous metal layer (C) is a layer formed by sintering a metallic fine particle dispersion material (E1) in which metallic fine particles including metallic fine particles (M1) having an average particle diameter of 1 nm to 500 nm are dispersed in an organic dispersion medium (S).
(6) The connection structure (I) as described in (5), wherein the metallic fine particles (M) are one or two or more metals selected from copper, gold, silver, nickel, and cobalt.
(7) The connection structure (I) as described in any one of (1) to (6), wherein a heat resistant resin (R) fills at least a portion of the porous metal layer of the outer peripheral side part (B) in the porous metal layer (C).
(8) A semiconductor apparatus (I) having the connection structure (I) as described in any one of (1) to (7) (hereinafter, also referred to as a second embodiment).
(9) A connection structure (II) for connecting a back side metallization of a semiconductor element to a substrate or a lead frame, wherein
   a fine copper layer (D1) and a porous copper layer (D2) are provided in the stated order so as to come into contact with at least the back side metallization of the semiconductor element, and
   the porosity of the fine copper layer (D1) is 1% or less and the porosity of the porous copper layer (D2) is from 2% to 15% (hereinafter, also referred to as a third embodiment).
(10) The connection structure (II) according to (9), wherein the thickness of the fine copper layer (D1) is from 0.1 µm to 10 µm.
(11) The connection structure (II) according to (9) or (10), wherein a heat resistant resin (R) fills at least a portion of the porous copper layer (D2).
(12) The connection structure (II) according to any one of (9) to (11), wherein the porous copper layer (D2) is a layer formed by sintering a copper fine particle dispersion material (E2) in which copper fine particles (P) are dispersed in a dispersion medium, and the average primary particle diameter of the copper fine particles (P) in the copper fine particle dispersion material (E2) is from 1 nm to 500 nm.
(13) The connection structure (II) according to any one of (9) to (12), wherein the back side metallization of the semiconductor element is a Ni layer coated with Ni or a Ni alloy.
(14) A semiconductor apparatus (II) having the connection structure (II) according to any of (9) to (13) (hereinafter, also referred to as a fourth embodiment).

### EFFECTS OF THE INVENTION

(i) The connection structure (I) according to a first embodiment of the present invention demonstrates an improved joint lifetime and is able to maintain heat dissipation and conductivity while improving joint reliability due to the fact that a back side metallization of a semiconductor element is joined to a substrate or a lead frame via a porous metal layer (C) in which the porosity of the outer peripheral side part (B) is greater than the porosity of the center side (A) positioned on the inside thereof as described above, due to the fact that stress generated on the joint interface between the back side metallization of the semiconductor element and the porous metal layer (C) and on the joint interface between the porous metal layer (C) and the side of the substrate or the lead frame is alleviated, and due to the fact that oxidization of the porous metal layer (C) is suppressed.
(ii) According to the connection structure (II) according to a third embodiment of the present invention, a fine copper layer (D1) having a porosity of 1% or less and a porous copper layer (D2) having a porosity of 2% to 15% are provided in the stated order on the back side metallization of the semiconductor element, whereby breaking strength and elongation at high temperatures of the porous copper layer (D2) is increased due to the increase in the surface area for binding the metals on the connection interfaces, and the connection strength among copper fine particles inside the porous copper layer (D2) and on the connection interface with the porous copper layer (D2) can be improved. Moreover, the apparent modulus of elasticity is lowered, stress applied to the semiconductor element can be alleviated, and the occurrence of breakage of the semiconductor element can be prevented due to the porous copper layer (D2) having vacancies.

### BRIEF DESCRIPTION OF THE DRAWINGS

FIG. 1 is an image-processed photograph in which a center side (A) cross-section of a porous metal layer obtained with the Example 3 is imaged with a scanning electron microscope (SEM) according to a first embodiment.
FIG. 2 is an image-processed photograph in which an outer peripheral side part (b) cross-section of the porous metal layer obtained with the Example 3 is imaged with a scanning electron microscope (SEM) according to the first embodiment.
FIG. 3 is a graph showing the relationship between the distance from the side of the porous metal layer to the center part obtained with the Examples 1, 3, and 5 and the porosity (%) according to the first embodiment.
FIGS. 4A to 4C are cross-sectional views schematically illustrating a sintering furnace used in the examples and comparative examples for describing the first embodiment.
FIG. 5 is a cross-sectional view schematically illustrating a connection construction for a connection structure (II) according to a second embodiment.

### EMBODIMENT FOR CARRYING OUT THE INVENTION

The following is a description of a [1] connection structure (I) (first embodiment), [2] a semiconductor apparatus (I) (second embodiment), [3] a connection structure (II) (third embodiment), and [4] a semiconductor apparatus (II) (fourth embodiment) of the present invention.

### Connection structure (first embodiment)

[1] The following is a description of (1-1) a connection structure (I) of a first embodiment and (1-2) a manufacturing method of the connection structure (I).

### [1-1] Connection structure (I) (first embodiment)

The connection structure (I) according to the first embodiment of the present invention is:
a connection structure (I) for connecting a back side metallization of a semiconductor element to a substrate or a lead frame, wherein
a porous metal layer (C) is provided so as to come into contact with at least a back side metallization of a semiconductor element, and the ratio [(B)/(A)] of a porosity of an intermediate portion in the thickness direction of an outer peripheral side part (B) of a region further towards the outside than a cross-section part formed at a position of a distance equivalent to the thickness of the porous metal layer (C) from the side surface of the porous metal layer (C) toward the inside, to the porosity of a center side (A) after having excluded the outer peripheral side part (B), falls within the range of 1.10 to 1.60.

When a metallic fine particle dispersion solution (E1) including nanoparticles with an average primary particle diameter of 1 nm to 500 nm is used in forming the porous metal layer (C), sintering may be performed at a relatively low temperature because the nanoparticles have a high surface activity and oxidation of the sintered compact obtained from the sintering is suppressed. Stress generated in the semiconductor element and the joint interface is alleviated, the lifetime of the joint can be improved, and heat dissipation and conductivity are maintained which allows joint reliability to be improved in the porous metal layer (C) which is a porous structure having vacancies due to the structure in which the porosity of the outer peripheral side part (B) is higher as described above in comparison to the center side (A) positioned on the inner side in the porous structure having vacancies.
(1) a substrate and a lead frame, (2) a semiconductor element, and (3) the porous metal layer (C) that constitute the connection structure of the present invention and (4) the formation of the porous metal layer (C) are described below.

### (1) Substrate and lead frame

A substrate formed by soldering or sputtering, brazing and the like a conductive pattern such as a copper plate on one surface of an insulating layer such as a ceramic layer, or a direct bonded copper (DBC) substrate in which an electrode plate is directly joined to a ceramic plate, are preferably used as the substrate used in the connection structure of the present invention. A metal plate such as a copper plate can be joined to the other surface of the substrate for dissipating heat. Alumina (Al₂O₃), aluminum nitride (AlN), silicon nitride (Si₃N₄) or the like are examples of ceramics. A lead frame in which a die pad is provided on the joining surface may be used instead of the substrate in the present invention. An improvement of heat dissipation can be expected when a semiconductor element is mounted on a lead frame.

### (2) Semiconductor element

The semiconductor element is an electronic component using a semiconductor or an element in the functional center part of the electronic component and is formed, for example, by assembling a semiconductor wafer with a substrate having an electrode for external connection, and then cutting (dicing) the assembly into chip units. The semiconductor element is provided with a back side metallization such as an alloy on a joint surface with a normal electrode.

### (3) Porous metal layer (C)

The porous metal layer (C) is formed from an outer peripheral side part (B) of a region further towards the outside than the cross-section part formed at a position of a distance equivalent to the thickness of the porous metal layer (C) from the side surface of the porous metal layer (C) toward the inside, and a center side (A) excluding the outer peripheral side part (B). The center side (A) which is a main constituent member of the porous metal layer (C) is a portion that influences properties such as conductivity, heat transfer, and mechanical strength. The outer peripheral side part (B) mainly acts to alleviate stress generated in the joint interface between the semiconductor element and the porous metal layer (C) and in the joint interface between the porous metal layer (C) and the substrate (or lead frame). The porous metal layer (C) is formed by sintering metallic fine particles (M) which will be described below and a manufacturing example of the porous metal layer (C) is described below.

### (3-1) Porosity of porous metal layer (C)

### (i) Porosity measurement method

The measurement of the porosity of the porous metal layer (C) in the present invention can be carried out by image processing by using a scanning electron microscope (SEM) (SEMEDX Type N, manufactured by Hitachi, Ltd.) to image a cross-sectional plane in the perpendicular direction of the porous metal layer, with an accelerating voltage during observation of 20.0 kV, a magnification during observation of 5000 times, and a working distance (WD) of 12.1 mm, to make a SEM image type with a secondary electron image.

Image processing is carried out by using image processing software (WinROOF manufactured by Mitani Corporation), and the processing range is set at 10 µm vertical by 20 µm horizontal of the SEM image. Binary processing is implemented using binarization with two threshold values. At this time, the two concentration (brightness) threshold values are set to 0 (minimum) and 100 (maximum). The surface area ratio is selected as the measurement item. In the surface area ratio, the parts not including the porous metal portions derived from the metallic fine particles (M) signify the porosity (%). The measurement of the porosity of the center side (A) in the present invention involves measuring the vicinity of the center point of the center side (A) of the porous metal layer (C). The porosity of the outer peripheral side part (B) is measured at an intermediate portion in the thickness direction of the outer peripheral side part (B). The porosity of the porous metal layer (C) refers to "a volumetric percent formed from matter other than metal" in the metal layer per unit volume, and the volume occupied by the heat resistant resin (R) other than the metal is included in "a volumetric percent formed from matter other than metal."

### (ii) Porosity of center side (A) and outer peripheral side part (B)

The ratio [(B)/(A)] of a porosity of an intermediate portion in the thickness direction of an outer peripheral side part (B) of the porous metal layer (C), to the porosity on the center side (A), falls within the range of 1.10 to 1.60.

Although the effect of alleviating the stress generated in the joint interface between the porous metal layer (C) and the substrate (or lead frame) is produced when the ratio [(B)/(A)] of the porosity exceeds the upper limit of the above range, there is a concern that the mechanical strength of the porous metal layer (C) would be reduced and material breakage within the porous metal layer (C) may easily occur. Conversely, if the ratio [(B)/(A)] of the porosity is less than the lower limit of the range described above, the function of alleviating the stress concentration generated in the semiconductor element, in the joint interface between the semiconductor element and the porous metal layer (C), and in the joint interface between the porous metal layer (C) and the substrate (or lead frame) may not be effectively demonstrated.

Vacancies in parts of the porous metal layer (C) having a higher porosity may easily deform and thus the modulus of elasticity in the vicinity of these parts tends to be lower while the modulus of elasticity in the vicinity of parts having a lower porosity tend to approach the modulus of the bulk modulus.

### (ii-1) Porosity of center side (A)

The porosity of the center side (A) of the porous metal layer (C) is preferably from 10.5% to 20.0%. Preferably, when the porosity of the center side (A) is 10.5% or more, the function of alleviating stress concentrations in the semiconductor element, in the joint interface between the semiconductor element and the porous metal layer (C), and in the joint interface between the porous metal layer (C) and the substrate (or lead frame) is effectively demonstrated. Conversely, when the porosity of the center side (A) is 20.0% or less, the required mechanical strength of the porous metal layer (C) is ensured and material breakage within the porous metal layer (C) can be suppressed.

### (ii-2) Porosity of outer peripheral side part (B)

Due to the ratio [(B)/(A)] of the porosity of the intermediate portion in the thickness direction in the outer peripheral side part (B) of the porous metal layer (C) to the porosity of the center side (A) being from 1.10 to 1.60 as mentioned above, stress generated in the semiconductor element, in the joint interface between the semiconductor element and the porous metal layer (C), and in the joint interface between the porous metal layer (C) and the substrate (or lead frame), is alleviated, oxidation is suppressed, and the lifetime of the joint can be improved and joint reliability can also be improved while maintaining heat dissipation and conductivity.

### (3-2) Modulus of elasticity of porous metal layer (C)

### (i) Method for measuring modulus of elasticity

Measurement of the modulus of elasticity of the porous metal layer (C) in the present invention uses a measurement method conforming to ISO 14577 Parts 1, 2, and 3. The modulus of elasticity may be measured using the model Nano Indenter G200 made by Toyo Corporation, for example, as the apparatus for measuring the modulus of elasticity.

The modulus of elasticity of the center side (A) of the porous metal layer (C) is derived as an average value of modulus of elasticity measurement values of the joint surface with the semiconductor element from a total of five locations including a center location of the center side (A) and four locations spaced away from each other at phases of 90-dgree centered around the center point in the vicinity of an intermediate point between the center point of the center side (A) and the edge part of the center side (A).

The modulus of elasticity of the outer peripheral side part (B) of the porous metal layer (C) is derived as an average value of modulus of elasticity measurement values of the joint surface with the semiconductor element from four locations in the outer peripheral side part (B) spaced away from each other at phases of 90-degree centered around the center point of the porous metal layer (C).

### (ii) Modulus of elasticity of center side (A) and outer peripheral side part (B)

A ratio [(B)/(A)] of the modulus of elasticity of the joint surface of the outer peripheral side part (B) with the semiconductor element to the modulus of elasticity of the joint surface of the center side (A) with the semiconductor element is preferably from 0.75 to 0.95 in the porous metal layer (C) of the present invention.

When the ratio [(B)/(A)] of the moduli of elasticity of the outer peripheral side part (B) and the center side (A) in the porous metal layer (C) exceed the upper limit of the range described above, the effect of alleviating the stress generated in the semiconductor element, in the joint interface between the semiconductor element and the porous metal layer (C), and in the joint interface between the porous metal layer (C) and the substrate (or lead frame) in the outer peripheral side part (B) tends to be reduced. Although the effect of alleviating the stress generated in the semiconductor element, in the joint interface between the semiconductor element and the porous metal layer (C), and in the joint interface between the porous metal layer (C) and the substrate (or lead frame) is produced when the ratio of the modulus of elasticity is less than the lower limit of the range described above, there is a concern that the mechanical strength of the porous metal layer (C) would be reduced and material breakage within the porous metal layer (C) may occur.

### (ii-1) Modulus of elasticity of center side (A)

The modulus of elasticity of the center side (A) is preferably from 49.0 GPa to 75.0 GPa.

Preferably, when the modulus of elasticity of the center side (A) is 75.0 GPa or less, the function of alleviating stress concentrations in the semiconductor element, in the joint interface between the semiconductor element and the porous metal layer (C), and in the joint interface between the porous metal layer (C) and the substrate (or lead frame) is effectively demonstrated. Conversely, when the modulus of elasticity of the center side (A) is 49.0 GPa or more, the required mechanical strength of the porous metal layer (C) is ensured and material breakage within the porous metal layer (C) can be suppressed.

### (ii-2) Modulus of elasticity of outer peripheral side part (B)

Due to the ratio [(B)/(A)] of the modulus of elasticity of the joint surface of the outer peripheral side part (B) with the semiconductor element to the modulus of elasticity of the joint surface of the center side (A) with the semiconductor element being 0.75 to 0.95, stress generated in the semiconductor element, in the joint interface between the semiconductor element and the porous metal layer (C), and in the joint interface between the porous metal layer (C) and the substrate (or lead frame) is further alleviated and the lifetime of the joint can be improved.

The modulus of elasticity is generally said to fall accompanying an increase in the porosity. However, because the apparent average particle diameter, the average vacancy diameter, and the number of vacancies per unit volume of the sintered metallic fine particles of the porous metal layer (C) formed are all different in the porous metal layer (C) of the present invention according to (a) the particle diameter of the metallic fine particles (M), the type of the organic dispersion medium (S), and the blending ratio of the metallic fine particles (M) and the organic dispersion medium (S) in the metallic fine particle dispersion (E1) used in the sintering, and (b) sintering conditions, it can be considered that there is not necessarily a constant relationship between the porosity and the modulus of elasticity and the properties are independent of each other.

### (4) Formation of porous metal layer (C)

As described below, the porous metal layer (C) is formed, for example, by either patterning or arranging a paste substance or a molded body composed of the metallic fine particle dispersion (E1) composed of the metallic fine particles (M) and the organic dispersion medium (S), on a pad part formed from a metal layer on a substrate, and then arranging the semiconductor element on the paste substance or the molded body to form a porous metal layer precursor (F), and then heating and sintering the porous metal layer precursor (F).

The metallic fine particle dispersion (E1) is preferably a dispersion solution having a relatively high viscosity, for example, a viscosity of 200 Pa·s or more, or a molded body.

### (i) Metallic fine particles (M)

At least one type of high-purity metallic fine particle can be used as-is for the metallic fine particles (M) used in the formation of the porous metal layer (C) as opposed to a solder paste, and thus the joint with superior joint strength and conductivity can be obtained. Although a typical solder paste contains flux (organic component) for removing oxidation of the copper pad portion of the substrate which is to be mounted, and often includes metals such as Al, Zn, Cd, or As in very small amounts as impurities included in the metal material, adverse effects from the organic component or the impurities are preferably avoided in the present invention.

The porous metal layer (C) can be formed by sintering metallic fine particles (M1) having an average particle diameter of the primary particles distributed in the organic dispersion medium (S) as mentioned below of 1 nm to 500 nm, or the porous metal layer (C) can be formed by sintering a mixture of the metallic fine particles (M1) and metallic fine particles (M2) having an average particle diameter of the primary particles of 0.5 µm to 50 µm distributed in the organic dispersion medium (S).

The metallic fine particles (M) are metallic fine particles having sinterability with good conductivity and thermal conductivity, and while gold, silver, copper, platinum, palladium, tungsten, nickel, iron, cobalt, tantalum, bismuth, lead, indium, tin, zinc, titanium, or aluminum may be considered, due to conductivity, thermal processing (sinterability), and ease of procurement on the market, copper, gold, silver, nickel, and cobalt are preferred among these metals, and copper is especially preferred according to the features of conductivity, thermal conductivity, processability, prevention of migration, and low cost.

The metallic fine particles (M) are particles having sinterability with good conductivity and thermal conductivity, and the average primary particle diameter of the metallic fine particles is preferably nanosize (particles of 1 µm or less). Specifically, the average primary particle diameter of the metallic fine particles (M1) is preferably from 1 nm to 500 nm. A porous body having equivalent particle diameters and vacancies can be formed by sintering with the average particle diameter of the primary particles of the metallic fine particle (M1) being 1 nm or more. Conversely, a fine conductive pattern can be formed with the average particle diameter of the primary particles being 500 nm or less.

When the metallic fine particles (M2) having an average primary particle diameter of 0.5 µm to 50 µm are used with the metallic fine particles (M1) having an average primary particle diameter of 1 nm to 500 nm as the metallic fine particles (M), the metallic fine particles (M1) are dispersed and present in a stable manner between the metallic fine particles (M2), whereby a difference in the particle diameters among the average primary particle diameters of the metallic fine particle (M1) can be ensured, free movement of the metallic fine particles (M1) during thermal processing can be effectively suppressed, and the dispersibility and stability of the metallic fine particles (M1) can be improved. When mixing and using the metallic fine particles (M2) in the metallic fine particles (M), the metallic fine particles (M1) among the metallic fine particles (M) are preferably from 80% to 95% by volume, and the metallic fine particles (M2) among the metallic fine particles (M) are preferably from 20% to 5% by volume (with the total % by volume being 100% by volume). Metal particles of the same type as described for the metallic fine particles (M1) are preferably used as the metallic fine particles (M2).

The average particle diameter of the primary particles herein refers to the diameter of the primary particles of each of the metallic fine particles that constitute the secondary particles. The primary particle diameter is a measurement value that can be measured from an image obtained using an electron microscope. The average particle diameter refers to the numerical average particle diameter of the primary particles that can be observed using an electron microscope.

### (ii) Organic dispersion medium (S)

One or two types of polyols having two or more hydroxyl groups in the molecule are preferably contained in the organic dispersion medium (S), and the melting point of the polyols is preferably from 30°C to 280°C. The polyols exhibit an action of dispersing the metallic fine particles (M) in the metallic fine particle dispersion (E1) and an action of promoting sintering by undergoing a dehydrogenation reaction and generating hydrogen radicals during heating and sintering.

One or two types selected from: ethylene glycol, diethylene glycol, 1,2-propanediol, 1,3-propanediol, 1,2-butanediol, 1,3-butanediol, 1,4-butanediol, 2-butene-1,4-diol, 2,3-butanediol, pentanediol, hexanediol, octanediol, glycerol, 1,1,1-tris hydroxymethyl ethane, 2-ethyl-2-hydroxymethyl-1,3-propanediol, 1,2,6-hexanetriol, 1,2,3-hexanetriol, 1,2,4-butanetriol, threitol, erythritol, pentaerythritol, pentitol, xylitol, ribitol, arabitol, hexitol, mannitol, sorbitol, dulcitol, glyceraldehyde, dihydroxyacetone, threose, erythrulose, erythrose, arabinose, ribose, ribulose, xylose, xylulose, lyxose, glucose, fructose, mannose, idose, sorbose, gulose, talose, tagatose, galactose, allose, altrose, lactose, xylose, arabinose, isomaltose, glucoheptose, heptose, maltotriose, lactulose, and trehalose, may be used as the polyol.

Other than the above polyols, an alcohol, an organic solvent having an amido group, an ether-based compound, a ketone-based compound, or an amine-based compound may be blended as components of the organic dispersion medium (S). A dispersion medium other than the above polyols is preferably blended to arrive at a 30% by volume or less in the organic dispersion medium (S).

### (iii) Component concentration in metallic fine particle dispersion (E1)

The concentration of the metallic fine particles (M) in the metallic fine particle dispersion (E1) is preferably from 70% to 90% by mass, or more preferably from 75% to 85% by mass. The viscosity of the metallic fine particle dispersion (E1) can be maintained at a high level in the above range and a porous metal layer (C) can be easily formed in which the porosity of the outer peripheral side part (B) is higher than that of the metal of the center side (A) positioned therein.

The flowability of the metallic fine particle dispersion (E1) is high if the concentration of the metallic fine particles (M) is less than 70% by mass, thus causing defects when coating or arranging the metallic fine particle dispersion (E1) to form the porous metal layer precursor (F). Conversely, if the concentration of the metallic fine particles (M) exceeds 90% by mass, the porosities in the porous metal layer (C) tend to become uniform.

The metallic fine particle dispersion (E1) may be a solution or a molded body having the metallic fine particles (M) dispersed therein.

### (iv) Viscosity of metallic fine particle dispersion (E1)

The viscosity of the metallic fine particle dispersion (E1), measured with a vibration-type viscometer and conforming to JIS Z8803 (2011), is preferably 200 Pa·s or more, or more preferably 400 Pa·s or more. The viscosity may be measured using, for example, the vibration-type viscometer, model VM100A, made by Sekonic Corporation. If the viscosity of the metallic fine particle dispersion (E1) is 200 Pa·s or more, the shape of the outer peripheral side part (B) flows and cannot be maintained when pressure is applied from the upper part of the semiconductor element during sintering, and a porous metal layer (C) can be obtained having a higher porosity in comparison to the center side (A) positioned on the inner side thereof, and the porous metal layer (C) in which the porosity of the outer peripheral side part (B) is higher than the porosity of the center side (A) can be formed. By adjusting the content ratio of the metallic fine particle (M) and the organic dispersion medium (S) in the metallic fine particle dispersion (E1), a viscosity of 200 Pa·s or more can be achieved.

When the viscosity of the metallic fine particle dispersion (E1) is less than 200 Pa·s, the metallic fine particle dispersion (E1) flows toward the periphery of the semiconductor element and forming the joint layer becomes difficult, and thus a portion of the organic dispersion medium (S) is evaporated by predrying the metallic fine particle dispersion (E1) and thus the viscosity needs to be increased. However, when predrying is performed, the peripheral parts of the porous metal layer precursor (F) is pressurized so as to be uniform with the center side when sintering under pressure, the porosity of the peripheral part thus does not become higher than the porosity of the center side after sintering and it becomes difficult to obtain a porous metal layer with a modulus of elasticity of the outer peripheral side part lower than that of the center side.

### (v) Porous metal layer precursor (F)

The porous metal layer precursor (F) is formed by coating (or patterning) or arranging a paste substance or a molded body composed of the metallic fine particle dispersion (E1) on the substrate (or lead frame), and then arranging the semiconductor element on the paste substance or the molded body. The porous metal layer precursor (F) is then heated and sintered to form the porous metal layer (C).

### (vi) Formation of porous metal layer (C)

The porous metal layer (C) of the present invention is formed by arranging the porous metal layer precursor (F) and the semiconductor element on the substrate (or lead frame) and then heating and sintering while applying pressure from the upper side of the semiconductor element.

### (vii) Filling heat resistant resin (R) in at least a portion inside the porous metal layer

When forming the porous metal layer (C) of the present invention, the heat resistant resin (R) is further blended into the metallic fine particle dispersion (E1) that includes the metallic fine particles (M) and the organic dispersion medium (S), whereby the heat resistant resin (R) is extruded with the organic dispersion medium (S) to the outer peripheral side during the sintering with a pressure applied from the upper side of the semiconductor element, and thus the porous metal layer (C) is easily formed in which the porosity of the outer peripheral side part (B) is higher than that of the center side (A) positioned on the inside thereof. In this case, the heat resistant resin (R) enters a state in which the heat resistant resin (R) fills at least a portion inside the metal layer of the outer peripheral side part (B) of the porous metal layer (C).

Moreover, when the heat resistant resin (R) is extruded to the outer peripheral side, at least a portion of the outer peripheral side surface of the porous metal layer (C) and/or of the semiconductor element is covered by a cover layer composed of the heat resistant resin (R), and deposition of the metallic fine particles from the side surface of the semiconductor element is prevented and a connection structure with good properties can be obtained.

A prepolymer solution or a resin solution may be considered as components for forming the heat resistant resin (R). An epoxy resin system having two or more epoxy groups in one molecule, or polyimide prepolymer solution may be considered as a component of the prepolymer solution. A resin such as a silicon resin, an amide-imide resin, a maleimide resin, or a polyvinyl pyrrolidone may be considered as the resin solution. The heat resistant resin (R) preferably has a deflection temperature under load of 150°C or higher, and a glass-transition temperature (Tg) of 100°C or higher.

### [1-2] Method for manufacturing connection structure (I)

The connection structure (I) of the first embodiment of the present invention is formed by coating (or patterning) or arranging a paste substance or a molded body composed of the metallic fine particle dispersion (E1) including the metallic fine particles (M) and the organic dispersion medium (S) on a substrate (or lead frame) composed of a metal layer such as a substrate, and arranging the semiconductor element on the paste substance or the molded body to form the porous metal layer precursor (F), and then heating and sintering the porous metal layer precursor (F) to form the porous metal layer (C), and by joining the substrate (or lead frame) with the semiconductor element via the porous metal layer (C).

In this case, the selection of the following conditions (a) to (e), for example, is preferable when forming the porous metal layer (C) in which the porosity of the outer peripheral side part (B) is higher than the porosity of the center side (A) positioned inside the outer peripheral side part (B).
(a) The metallic fine particles (M) having an average primary particle diameter of 1 nm to 500 nm and the organic dispersion medium (S) are included in the metallic fine particle dispersion (E1), (b) the content of the metallic fine particles (M) in the metallic fine particle dispersion (E1) is from 70% to 90% by mass, (c) the coating surface area of the porous metal layer precursor (F) is from 9 mm² to 225 mm², (d) the sintering of the porous metal layer precursor (F) is carried out with a pressure of 4 MPa to 20 MPa being applied from the upper side of the semiconductor element, and (e) sintering is carried out at a constant temperature after increasing the temperature at a temperature elevation rate of 5 to 20°C/minute.

Conventionally, metallic powder is subject to compression molding and densification is attempted to provide a uniform density ("Sintered Material Engineering" by Tsuneo ISHIDA, Morikita Publishing Co., Ltd., published on 28 March 1997, page 69). There is a relationship between making the size of vacancy diameters uniform and making powder fillers uniform in order to make the microstructure of a sintered compact uniform during liquid phase sintering. It is known that when vacancy diameters are uniform, the flow of the liquid phase into the vacancies due to capillary flow is stopped and the sintering advances in a uniform manner ("Liquid Phase Sintering" by Randall M. German (translated into Japanese by Yusuke MORIYOSHI et al.), Uchida Rokakuho Publishing Co., Ltd., published on 25 June 1992, page 226).

Meanwhile, the porous metal layer (C) obtained by selecting the above sintering conditions when manufacturing the connection structure (I) of the present invention demonstrates a reduction in hardness and modulus of elasticity due to the fact that the porosity of the outer peripheral side part (B) is higher than that of the center side (A) positioned inside the outer peripheral side part (B), and consequently stress generated in the semiconductor element, in the joint interface between the semiconductor element and the porous metal layer (C), and in the joint interface between the porous metal layer (C) and the substrate (or lead frame) is alleviated, oxidation is suppressed, and the lifetime of the joint is improved and the reliability of the joint is improved while maintaining heat dissipation and conductivity.

An example of a method for manufacturing the connection structure (I) of the first embodiment of the present invention is described below.

When forming the porous metal layer (C) of the present invention, the following conditions (a) to (c) are preferably selected in order to coat (or pattern) or arrange the paste substance or the molded body composed of the metallic fine particle dispersion (E1) on the substrate (or lead frame), arrange the semiconductor element on the paste substance or the molded body to form the porous metal layer precursor (F), and then, during heating and sintering, form a structure in which the porosity of the outer peripheral side part (B) is higher than that of the center side (A) positioned inside the outer peripheral side part (B).

### (a) The coating surface area of the porous metal layer precursor (F) on substrate (or lead frame)

The coating surface area of the porous metal layer precursor (F) on the substrate (or lead frame) is preferably from 9 to 225 mm². The porous metal layer (C) in which the porosity of the outer peripheral side part (B) is higher than that of the center side (A) positioned inside the outer peripheral side part (B) can be obtained when the coating surface area is 9 mm² or more, and adverse effects from thermal stress are reduced and consequently interface peeling and cracking is less likely to occur when the coating surface area is 225 mm² or less.

### (b) Pressure to be applied from upper side of semiconductor element when sintering porous metal layer precursor (F)

The porous metal layer precursor (F) is preferably sintered with a pressure of 5 MPa to 20 MPa from the upper side of the semiconductor element.

The porous metal layer (C) in which the porosity of the outer peripheral side part (B) is higher than that of the center side (A) positioned inside the outer peripheral side part (B) can be obtained when the pressure to be applied is 5 MPa or more, but there is a concern that the semiconductor element would be damaged if the pressure to be applied exceeds 20 MPa.

### (c) Sintering conditions of porous metal layer precursor (F)

The porous metal layer precursor (F) is preferably sintered at a constant temperature after increasing the temperature at a temperature elevation rate of 5 to 20°C/minute. The porous metal layer (C) in which the porosity of the outer peripheral side part (B) is higher than that of the metal of the center side (A) positioned inside the outer peripheral side part (B) can be formed easily by keeping the temperature elevation rate within the above range. If the temperature elevation rate exceeds 20°C/minute, there is a concern that the porous metal layer precursor (F) would bump and voids would be formed, and if the temperature elevation rate falls below 5°C/minute, productivity would be reduced.

While the mechanism in which the structure in which the porosity of the outer peripheral side part (B) is higher than the porosity of the center side (A) positioned inside the outer peripheral side part (B) in the porous metal layer (C) is formed cannot be precisely understood, it is considered that the organic dispersion medium (S) vaporized or decomposed and gasified during sintering is formed as a gaseous substance so that relatively more of the organic dispersion medium (S) passes through the vicinity the outer peripheral part than the vicinity of the center part. When the metallic fine particle dispersion (E1) contains the heat resistant resin (R), it is assumed that, when the porous metal layer precursor (F) is pressurized from the upper side of the semiconductor element during sintering, the resin exhibits a phenomenon of being extruded in the vicinity of the outer peripheral part and thus the structure in which the porosity of the outer peripheral side part (B) is higher than that of the center side (A) positioned inside the outer peripheral side part (B) is easily formed.

### [2] Semiconductor apparatus (I) (Second Embodiment)

The semiconductor apparatus (I) of the second embodiment is a semiconductor apparatus characterized by having the connection structure (I) of the first embodiment.

While a method in which the semiconductor apparatus, which is a apparatus that electrically connects the semiconductor element (chip) and an external line circuit, is typically mounted on a printed wiring board includes an insertion mounting type and a surface mounting type, and the category based on the arrangement of external terminals includes a peripheral type in which the external terminals are arranged around the main body of a stacked structural body, and an area array type in which the external terminals are arranged on the face of the stacked structural body, the semiconductor apparatus that has the connection structure (I) of the first embodiment is not limited to the above types and is included in the semiconductor apparatus (I) of a second embodiment.

### [3] Connection structure (Third Embodiment)

The following is a description of (3-1) a connection structure (II) of a third embodiment and (3-2) a manufacturing method of the connection structure (II).

### [3-1] Connection structure (II) (Third Embodiment)

The connection structure (II) of the third embodiment of the present invention is the connection structure (II) for connecting the back side metallization of the semiconductor element to a substrate or a lead frame, wherein, a fine copper layer (D1) and a porous copper layer (D2) are provided in the stated order so as to come into contact with the back side metallization of the semiconductor element, and

the porosity of the fine copper layer (D1) is 1% or less and the porosity of the porous copper layer (D2) is from 2% to 15%.

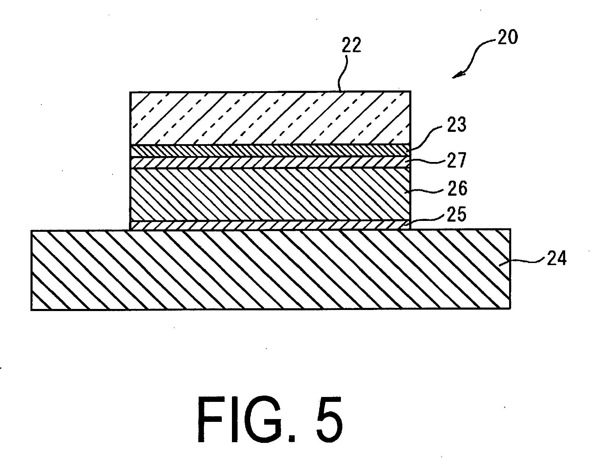

As illustrated in FIG. 5, a connection structure (II) 20 according to the third embodiment is a connection structure for connecting a back side metallization 23 of a semiconductor element 22 with a pad 25 of a substrate 24, and is provided with a fine copper layer (D1) 27 having a porosity of 1% or less and provided so as to come into contact with the back side metallization 23, and a porous copper layer (D2) 26 having a plurality of vacancies thereinside, having a porosity of 2% to 15%, and provided so as to come into contact with the fine copper layer (D1).

The back side metallization 23 of the semiconductor element 20 includes a Ni layer coated with Ni or a Ni alloy, and the fine copper layer (D1) 27 is formed so as to come into contact with the Ni layer.

While the connection structure (II) of the third embodiment is a connection structure for connecting the semiconductor element 22 and the substrate 24, the connection structure (II) may also be a connection structure for connecting the semiconductor element 22 and a lead frame instead of the substrate 24. The connection structure (II) may be applied to a so-called chip-on-chip structure that connects the semiconductor element 22 to another semiconductor element.

While the porous copper layer (D2) 26 in the third embodiment is formed from copper, the porous copper layer (D2) 26 may also be formed from a copper alloy. In this case, the content of copper in the copper alloy is preferably 60% by mass or more.

Next, the connection structure (II) according to the third embodiment will be explained.

### (1) Fine copper layer (D1)

The fine copper layer (D1) 27 is provided so as to come into contact with the back side metallization 23 of the semiconductor element 22 and is composed of a copper layer with a porosity of 1% or less. Localized stress concentrations generated in the semiconductor element 22 and in the joint interfaces can be alleviated and the long-term reliability can be improved by providing the fine copper layer (D1).

The thickness of the fine copper layer (D1) is preferably from 0.1 to 10 µm. When the thickness of the fine copper layer (D1) is equal to or more than 0.1 µm, the generation of penetrating pin holes can be suppressed and the effect of alleviating localized stress concentrations is further improved. Conversely, when the thickness of the fine copper layer (D1) is equal to or less than 10 µm, the effect of absorbing stress applied to the entire body due to vacancies in the porous copper layer (D2) is more effectively demonstrated.

### (2) Porous copper layer (D2)

The porous copper layer (D2) is composed of a copper layer having a large number of vacancies thereinside. By using copper as the metal material, adhesion with other components can be further improved unlike silver. Moreover, because breakage of the semiconductor element can be prevented even with a lower porosity in comparison to the use of silver in the porous metal layer, the porosity can be reduced and breaking strength and elongation at high temperature can be increased.

A vacancy is a portion in which copper formed in the porous copper layer (D2) is not present, and at least a portion of the vacancies may be filled with the heat resistant resin (R). That is, there may be vacancies completely filled with the heat resistant resin (R) and there may be vacancies which are not filled with the heat resistant resin (R). The size of the vacancies is preferably an average maximum width from 10 nm to 1000 nm.

When the lower limit of the average maximum width is less than 10 nm, the stress that is generated by the difference in coefficients of linear expansion among the semiconductor element, the back side metallization, and the substrate may not be effectively absorbed when the copper materials that constitute the porous copper layer (D2) expand due to heat. If the upper limit of the average maximum width exceeds 1000 nm, conductivity may be reduced. The average maximum width of the vacancies can be found as follows. An image is made by scanning an area within 500 µm from the center in the cross-sectional plane of the porous copper layer (D2) using a scanning electron microscope (SEM), and 20 sample vacancy portions that appear dark in the image are extracted, the maximum width of one vacancy is measured, and the average value of the maximum vacancy width of the 20 sample vacancies is taken to be the "average maximum width".

The porosity of the porous copper layer (D2) is from 2% to 15%. The measurement of the porosity of the porous metal layer (C) in the present invention can be carried out by image processing by using a scanning electron microscope (SEM) (SEMEDX Type N, manufactured by Hitachi, Ltd.) to image a cross-sectional plane in the perpendicular direction of the porous metal layer, with an accelerating voltage during observation of 20.0 kV, a magnification during observation of 5000 times, and a working distance (WD) of 12.1 mm, to make a SEM image type with a secondary electron image. Image processing is carried out by using image processing software (WinROOF manufactured by Mitani Corporation), and the processing range is set at 10 µm vertical by 20 µm horizontal of the obtained SEM image. Binary processing is implemented using binarization with two threshold values. At this time, the two concentration (brightness) threshold values are set to 0 (minimum) and 100 (maximum). The surface area ratio is selected as the measurement item. In the surface area ratio, the parts not including the porous metal portions derived from the metallic fine particles (M) signify the porosity (%).

If the porosity exceeds 15%, the surface area for joining the metal layers of the joint interface is reduced and thus the breakage stress and elongation at high temperatures of the porous copper layer (D2) are reduced and there is a concern that the joint strength between the joint interfaces may be reduced in shear testing. If the porosity is less than 2%, there is a concern that cracking of the semiconductor element may occur during temperature cycling test (TCT) because the stress applied to the semiconductor element due to the difference in the coefficient of linear expansion due to temperature variation among the components is not alleviated.

The porous copper layer (D2) is preferably formed by sintering copper fine particles. The vacancies of the porous copper layer (D2) may similarly contain the heat resistant resin (R) such as a polyamide, an epoxy resin, a polyimide, or a polyvinylpyrrolidone as described in the first embodiment.

The average particle diameter (average particle diameter of primary particles) of the copper fine particles is preferably from 1 to 500 nm. The porous copper layer (D2) having homogeneous particle diameters and vacancies after sintering can be formed by setting the average particle diameter of the primary particles of the copper fine particle to 1 nm or more. The generation of areas in which localized stress cannot be alleviated can be prevented by setting the average particle diameter of the primary particles of the copper fine particle to 500 nm or less.

The average particle diameter of the primary particles herein signifies the average of the diameter of the primary particles which are individual copper fine particles that constitute the secondary particles. These primary particle diameters can be measured using an electron microscope. Further, the average particle diameter means a number-average particle diameter of the primary particles. Copper fine particles with the average particle diameter of the primary particles being from 1 to 500 nm preferably form 70% by mass or more of the entirety, and more preferably 80% by mass or more. Metallic fine particles having a particle diameter of primary particles of 5 to 50 µm may be included other than the copper fine particles.

By forming the porous copper layer (D2) by sintering the copper fine particles, vacancies are formed in the gaps between the copper fine particles.

The thickness of the porous copper layer (D2) is preferably from 5 µm to 300 µm. In a high temperature environment, the difference in the coefficient of linear expansion between the semiconductor element and the substrate or the lead frame increases, and thus there is a risk that breakage of the semiconductor element, the fine metal layer, or the substrate may occur. However, by providing the porous copper layer (D2), the difference in the above linear expansion is alleviated and the breakage may be prevented. The thickness of the porous copper layer (D2) is preferably increased up to the range in which the linear expansion differences can be alleviated.

### (3) Semiconductor element and substrate or lead frame

The semiconductor element, the back side metallization provided on the joint surface of the semiconductor element, and the substrate or the lead frame according to the third embodiment are the same as the contents described with regard to the first embodiment.

### [3-2] Method for manufacturing connection structure (II) (third embodiment)

A method for manufacturing the connection structure (II) according to the third embodiment is exemplified herein. The third embodiment of the present invention is not limited to the method exemplified below.

First, the fine copper layer (D1) is formed on the Ni layer that is the back side metallization 23 of the semiconductor element 22.

The fine copper layer (D1) can be formed by coating copper on the Ni layer for example. Next, the copper fine particle dispersion material (E2) having dispersed in the dispersion medium the copper fine particles that are the materials of the porous copper layer (D2) 26, is coated or patterned on the pad 25 of the substrate 24.

The organic dispersion medium (S) described in the first embodiment may be used as the dispersion medium.

Next, the fine copper layer (D1) formed on the semiconductor element is placed on the copper fine particle dispersion material (E2) provided on the substrate or the lead frame. The copper fine particles included in the copper fine particle dispersion material (E2) are sintered in this state. At this time, the porous copper layer (D2) is formed by sintering the particles of the copper fine particle together, and the pads between the copper fine particles and the fine copper layer (D1) and between the copper fine particles and the substrate are bonded.

The sintering of the copper fine particles is preferably performed in a reducing gas atmosphere, an inert gas atmosphere, or a vacuum. The reducing gas atmosphere is an atmosphere of a reducing gas such as hydrogen gas, and the inert gas atmosphere is an atmosphere of an inert gas such as nitrogen. By sintering in such an atmosphere, oxidation of the fine copper layer (D1) and the porous copper layer (D2) can be prevented, and furthermore, the formation of an oxidation layer on the surface of the copper fine particles is suppressed, and the sinterability of the copper fine particles can be improved. The sintering may preferably be performed under pressure due to the blending quantity of the dispersion medium for blending the copper fine particle dispersion material (E2) and the properties thereof.

While the connection surface area of bodies to be connected may not be guaranteed and bonding may not occur due to noticeable volume changes of the porous copper layer (D2) when only thermal processing is carried out, in such a case, the porosity can be reduced, the connection surface area between bodies to be connected is increased, and the desired joint strength can be achieved by using pressurization.

### [4] Semiconductor apparatus (II) (fourth embodiment)

The semiconductor apparatus (II) of a fourth embodiment is a semiconductor apparatus characterized by having the connection structure (II) of the third embodiment.

While a method in which the semiconductor apparatus, which is an apparatus that electrically connects the semiconductor element (chip) and an external line circuit, is typically mounted on a printed wiring board includes an insertion mounting type and a surface mounting type, and the category based on the arrangement of external terminals includes a peripheral type in which the external terminals are arranged around the main body of a stacked structural body, and an area array type in which the external terminals are arranged on the face of the stacked structural body, the semiconductor apparatus that has the connection structure (II) of the third embodiment is not limited to the above types and is included in a semiconductor apparatus (II) of the fourth embodiment.

### EXAMPLES

The following is a detailed explanation through examples of [1] the connection structure of the first embodiment and [2] the connection structure of the third embodiment. The present invention is not limited to these examples.

First, examples and comparative examples of the first embodiment of the present invention will be explained.

### [1] Examples 1-6 and Comparative Examples 1-15 of the first embodiment of the present invention

(1) The raw materials, (2) the sintering apparatus, and (3) the evaluation method used in the examples and comparative examples are described below.

### (1) Raw materials

### (i) Substrate

A DBC substrate (Cu/alumina/Cu) was used as the substrate. The DBC substrate has a Cu plate with a thickness of 0.1 mm, a ceramic plate with a thickness of 0.635 mm, and a Cu plate with a thickness of 0.1 mm.

### (ii) Metallic fine particle dispersion solution

### (ii-1) Metallic fine particle dispersion solution (1)

A copper fine particle dispersion solution (1) was used in which copper fine particles with an average primary particle diameter of 20 nm were dispersed at a concentration of 80% by mass in diethylene glycol. 2% by mass of polyvinylpyrrolidone was blended in the copper fine particle dispersion solution (1) as a polymeric dispersing agent.

### (ii-2) Metallic fine particle dispersion solution (2)

A copper fine particle dispersion solution (2) was used in which copper fine particles with an average primary particle diameter of 20 nm were dispersed at a concentration of 60% by mass in diethylene glycol. 2% by mass of polyvinylpyrrolidone was blended in the copper fine particle dispersion solution (2) as a polymeric dispersing agent.

### (ii-3) Metallic fine particle dispersion solution (3)

A silver metallic fine particle dispersion solution (3) was used in which silver metallic fine particles with an average primary particle diameter of 20 nm were dispersed at a concentration of 90% by mass in octanediol. 2% by mass of polyvinylpyrrolidone was blended in the silver metallic fine particle dispersion solution (3) as a polymeric dispersing agent.

### (iii) Semiconductor element

### (iii-1) Semiconductor element (1)

The size of the semiconductor element (1) was 7 mm × 7 mm with a thickness of 230 µm, and the joint surface thereof was metalized with a Ti-Ni-Au alloy. The semiconductor element (1) was used when fabricating samples for measuring porosity and for temperature cycle testing.

### (iii-2) Semiconductor element (2)

The semiconductor element (2) had the same size as the semiconductor element (1) and was not metalized as described above so that the joint surface between the semiconductor element and the porous metal layer could be easily separated after sintering the porous metal layer precursor in order to measure the modulus of elasticity of the porous metal layer.

### (2) Sintering apparatus

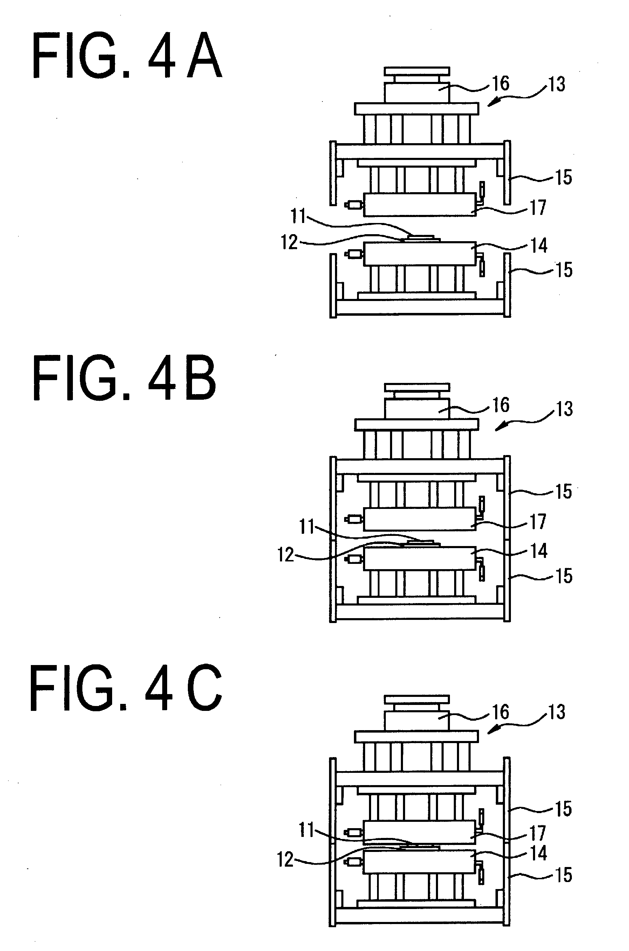

The porous metal layer was formed by sintering the porous metal layer precursor with the following operations using the sintering apparatus illustrated in FIGS. 4A to 4C.

A press plate 12 for laying as illustrated in FIGS. 4A to 4C was prepared, and a workpiece 11 was laid on the press plate 12 and set on a lower heating platen 14 of a vacuum press 13. Next, as illustrated in FIG. 4B, a chamber 15 was closed so that the inside of the chamber 15 entered a vacuum state. Then, as illustrated in FIG. 4C, the workpiece 11 was clamped between tan upper heating platen 17 and the lower heating platen 14 and heated while a pressure was applied with a pressurizing cylinder 16. By heating and sintering, the porous metal layer precursor was sintered to form the porous metal layer.

### (3) Evaluation method

### (i) Porosity measurement

### (i-1) Porosity measurement method

The measurement of the porosity of the porous metal layer (C) in the present invention could be carried out by using a scanning electron microscope (SEM) (SEMEDX Type N, manufactured by Hitachi, Ltd.) on a cross-sectional plane in the perpendicular direction of the porous metal layer, with an accelerating voltage during observation of 20.0 kV, a magnification during observation of 5000 times, and a working distance (WD) of 12.1 mm, by making a SEM image type with a secondary electron image. Image processing was carried out by using image processing software (WinROOF manufactured by Mitani Corporation), and the processing range was set at 10 µm vertical by 20 µm horizontal of the SEM image. Binary processing was implemented using binarization with two threshold values. At this time, the two density (brightness) threshold values were set to 0 (minimum) and 100 (maximum). At this time, the two concentration (brightness) threshold values were set to 0 (minimum) and 100 (maximum). The surface area ratio was selected as the measurement item. In the surface area ratio, the parts not including the porous metal portions derived from the metallic fine particles (M) signify the porosity (%). The measurement of the porosity of the center side (A) in the present invention involves measuring the vicinity of the center point of the center side (A) of the porous metal layer (C).

### (i-2) Locations for measuring porosity

The porosity of the center side (a) excluding the outer peripheral side part (b) of a region further toward the outside than the cross-section part formed at a position of a distance equivalent to the thickness of the porous metal layer from the side surface of the porous metal layer toward the inside, was measured at an intermediate portion in the thickness direction of the cross-sectional plane center side (a) in the horizontal direction of the porous metal layer, in the cross-sectional plane in the vertical direction of the thickness direction of the belowmentioned porous metal layers (11 to 61 and C1-1 to C1-15). The porosity of the outer peripheral side part (b) was measured at an intermediate portion in the thickness direction of the outer peripheral side part (b) in the cross-sectional plane in the horizontal direction of the porous metal layer.

### (ii) Modulus of elasticity measurement

### (ii-1) Method for measuring modulus of elasticity

The modulus of elasticity measurement involves measuring the modulus of elasticity of the porous metal layer using a Continuous Stiffness Measurement (CSM) using a push-in head and conforming to ISO 14577 Parts 1, 2 and 3. A Nano Indenter G200 manufactured by Toyo Corporation was used as the measurement apparatus.

### (ii-2) Modulus of elasticity measurement locations

The modulus of elasticity of the center side (A) was derived as an average of moduli of elasticity of the surface for joining with the semiconductor element (2) from a total of five locations including a center location of the center side (a) of the porous metal layer and four locations spaced away from each other at phases of 90-degree centered around the center point in the vicinity of an intermediate point between the center point of the center side (a) and the edge part of the center side (a), after the semiconductor elements (2) joined to the below mentioned porous metal layers (12 to 62, C2-1 to C2-15) had been peeled off and removed.

The modulus of elasticity of the outer peripheral side part (b) was derived as an average of moduli of elasticity of the surface for joining with the semiconductor element (2) from a total of four locations spaced away from each other at phases of 90° centered around the center point of the porous metal layer, after the semiconductor elements (2) joined to the porous metal layers had been peeled off and removed.

### (iii) Temperature cycling test (TCT)

Ten samples in which the semiconductor element (1) is joined to the copper plate of the DBC substrate via the porous metal layer were fed into a temperature cycling test (cycling test that evaluates resistance to temperature variation with one cycle involving holding a sample at +175°C for 30 minutes and then holding the sample at -55°C for 30 minutes), and the number of cycles for the peeling surface area to reach 20% or more was observed using ultrasonic inspection. The observation of the peeling surface area using ultrasonic inspection includes observing both the surface area between the pad parts of the substrate and the porous metal layer, and the surface area between the porous metal layer and the semiconductor element. Reliability evaluation standards are as described below.
A: 3000 TCT cycles or more
B: 1000 TCT cycles or more and less than 3000 cycles
C: 700 TCT cycles or more and less than 1000 cycles
D: Less than 700 TCT cycles

### [Example 1]

### (1) Formation of porous metal layer precursors (1) and (2)

A total of eleven porous metal layer precursors (1): one for porosity measurement and ten for temperature cycling test were formed by arranging 10 mm × 10 mm molded bodies composed of the metallic fine particle dispersion solution (1) and having a thickness of 350 µm on the copper plate of the DBC substrates, and then arranging the semiconductor elements (1) on the molded bodies.

A porous metal layer precursor (2) for measuring modulus of elasticity was formed by arranging a 10 mm × 10 mm molded body composed of the metallic fine particle dispersion solution (1) and having a thickness of 350 µm on the copper plate of the DBC substrate and then arranging the semiconductor element (2) on the molded body.

### (2) Formation of porous metal layers (11) and (12)

The DBC substrates having the semiconductor elements (1) arranged on the porous metal layer precursors (1) or having the semiconductor elements (2) arranged on the porous metal layer precursors (2) were heated and sintered using the sintering apparatus illustrated in FIGS. 4A to 4C to obtain the porous metal layer precursors described below.

Three mold release agents (PTFE sheets) each having a thickness of 30 µm were stacked on the semiconductor elements (1) and (2), and the heating was started at the same time at a temperature elevation rate of 10°C/minute while pressurizing from the upper side of the semiconductor element at a pressure of 5.0 MPa with the upper heating platen under a reduced pressure atmosphere (vacuum pressure of 1 kPa), and after the temperature reached 300°C, the temperature was maintained for 20 minutes. The samples were then cooled and unloaded.

Due to the above sintering, the porous metal layers (11) and (12) were formed from the porous metal layer precursors (1) and (2) having respectively the semiconductor elements (1) and (2) arranged thereon and the semiconductor elements (1) and (2) were joined to the copper plates of the DBC substrates via the porous metal layers.

The thickness of the porous metal layer (11) used for measuring the porosity was 203 µm.

The porous metal layers (11) and (12) were evaluated as follows.

### (3) Evaluations

### (i) Porosity measurement

### (i-1) Measurement of porosity of center side (a) and outer peripheral side part (b)

The porous metal layer (11) was sheared in the vertical direction at a position approximately half way through the thickness thereof, and five locations of the center side (a) and four locations of the outer peripheral side part (b) were measured as described above.

The average values of the measurements are shown in Table 1.

### (i-2) Measurement of porosity at eight locations from the side surface toward the inside of the porous metal layer (11)

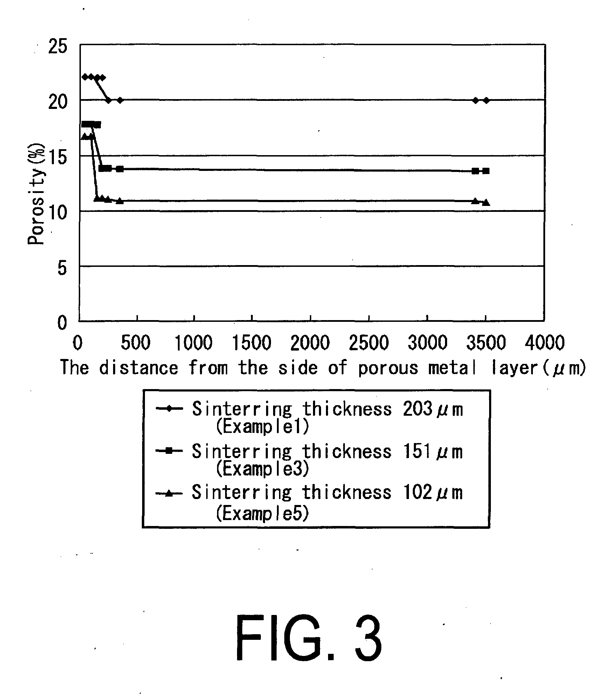

Porosity was measured at positions 3400 µm and 3500 µm from the side surface, and 350 µm from the side surface side toward the inside at a pitch of 50 µm in the cross-sectional plane of the porous metal layer (11). The results are shown in Table 2 and the results of Table 2 are plotted in FIG. 3. As illustrated in Table 2 and FIG. 3, it can be found that in the outer peripheral side part (b), the porosity increased from the position roughly equivalent to the thickness from the side surface of the porous metal layer (11) and that the porosity of the center side (a) was approximately uniform.

### (ii) Modulus of elasticity measurement

The modulus of elasticity of the center side (a) and the outer peripheral side part (b) was measured from the outer surface side of the porous metal layer (12) after the porous metal layer (12) obtained through sintering was peeled away from the semiconductor element (2). The results are shown in Table 1.

### (iii) Temperature cycling test (TCT)

Temperature cycling tests were performed on ten samples in which the porous metal layer (11) was formed on the copper plate of the DBC substrate.

The results of (i) to (iii) are summarized in Table 1.

### [Example 2]

### (1) Formation of porous metal layer precursors (1) and (2) and formation of porous metal layers (21) and (22)

The semiconductor elements (1) and (2) were used, and when the porous metal layer precursors (1) and (2) were heated and sintered, sintering was carried out with the heating and sintering conditions the same as those described for Example 1 except that a pressure of 7.5 MPa was applied from the upper side of the respective semiconductor elements, and the semiconductor elements (1) and (2) were joined to the copper plates of the DBC substrates via the respective porous metal layers (21) and (22).

The porous metal layers (21) and (22) were evaluated as follows.

### (2) Evaluations

### (i) Measurement of porosity of center side (a) and outer peripheral side part (b)

As described in Example 1, the porosities of the porous metal layer (21) at the center side (a) and at the outer peripheral side part (b) were measured.

### (ii) Measurement of modulus of elasticity of center side (a) and outer peripheral side part (b)

As described in Example 1, the moduli of elasticity of the porous metal layer (22) at the center side (a) and at the outer peripheral side part (b) were measured.

### (iii) Temperature cycling test (TCT)

Temperature cycling tests were performed on ten samples in which the porous metal layer (21) was formed on the copper plate of the DBC substrate in the same way as described in Example 1.

The results of (i) to (iii) are summarized in Table 1.

### [Example 3]

### (1) Formation of porous metal layer precursors (1) and (2)

As described in the Example 1, eleven porous metal layer precursors (1) and one porous metal layer precursor (2) were formed by arranging the precursors composed of the metallic fine particle dispersion solution (1) on the copper plate of the DBC substrates, and arranging the semiconductor elements (1) and (2) on the precursors.

### (2) Formation of porous metal layers (31) and (32)

The semiconductor elements (1) and (2) were used and when the porous metal layer precursors (1) and (2) were heated and sintered, sintering was carried out with the heating and sintering conditions the same as those described for Example 1 except that a pressure of 10.0 MPa was applied from the upper side of the respective semiconductor elements, the porous metal layers (31) and (32) were formed from the porous metal layer precursors (1) and (2), and the semiconductor elements (1) and (2) were joined to the copper plates of the DBC substrates via the respective porous metal layers. The thickness of the porous metal layer (31) used for measuring the porosity was 151 µm.

The porous metal layers (31) and (32) were evaluated as follows.

### (3) Evaluations

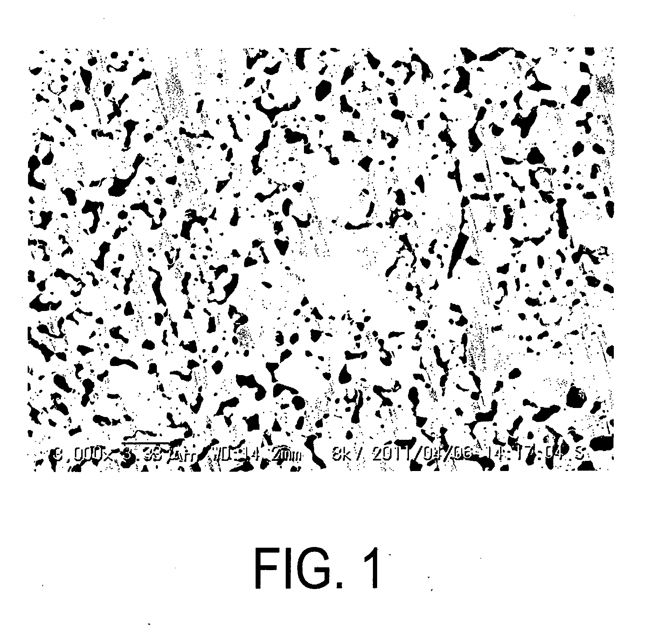

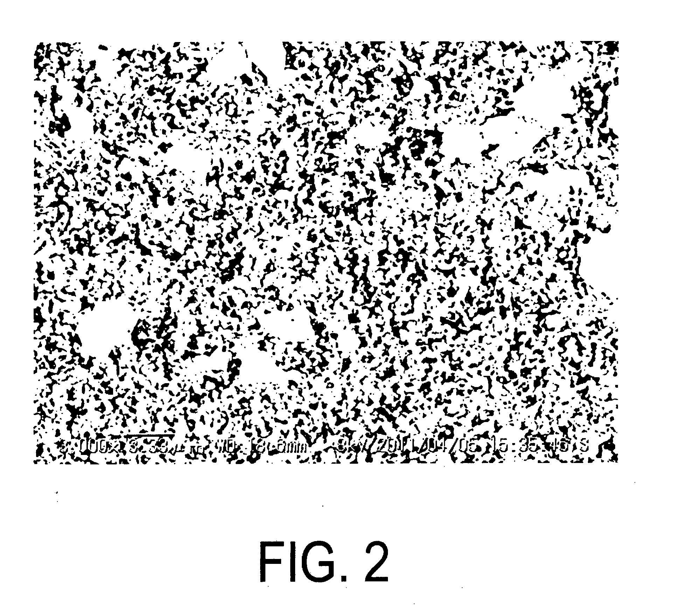

FIGS. 1 and 2 show photographs processed by imaging images obtained with a scanning electron microscope (SEM) of the cross-section of the outer peripheral part and the cross-section of the center part cut in the vertical direction at positions approximately half way through the thickness of the porous metal layer (31) obtained in Example 3. The magnification in both FIGS. 1 and 2 was 3000 times.

### (i) Porosity measurement

### (i-1) Measurement of porosity of center side (A) and outer peripheral side part (B)

As described in Example 1, the porosities of the porous metal layer (31) at the center side (A) and at the outer peripheral side part (B) were measured.

### (i-2) Measurement of porosity at eight locations from the side surface toward the inside of the porous metal layer (31)

Porosity was measured at positions 3400 µm and 3500 µm from the side surface, and 350 µm from the side surface side toward the inside at a pitch of 50 µm in the cross-sectional plane of the porous metal layer (31) in the same way as described in Example 1. The results are shown in Table 2 and the results of Table 2 are plotted in FIG. 3. As illustrated in Table 2 and FIG. 3, it can be found that in the outer peripheral side part (b), the porosity increased from the position roughly equivalent to the thickness from the side surface of the porous metal layer (31) and that the porosity of the center side (a) was approximately constant.

### (ii) Measurement of modulus of elasticity of center side (a) and outer peripheral side part (b)

As described in Example 1, the moduli of elasticity of the porous metal layer (32) at the center side (a) and at the outer peripheral side part (b) were measured.

### (iii) Temperature cycling test (TCT)

Temperature cycling tests were performed on ten samples in which the porous metal layer (31) was formed on the copper plate of the DBC substrate in the same way as described in Example 1.

The results of (i) to (iii) are summarized in Table 1.

### [Example 4]

### (1) Formation of porous metal layer precursors (1) and (2) and formation of porous metal layers (41) and (42)

The semiconductor elements (1) and (2) were used and when heating and sintering the porous metal layer precursors (1) and (2), sintering was carried out with the heating and sintering conditions the same as those described for Example 1 except that a pressure of 12.5 MPa was applied from the upper side of the respective semiconductor elements, and the semiconductor elements (1) and (2) were joined to the copper plates of the DBC substrates via the respective porous metal layers (41) and (42).

The porous metal layers (41) and (42) were evaluated as follows.

### (2) Evaluations

### (i) Measurement of porosity of center side (a) and outer peripheral side part (b)

As described in Example 1, the porosities of the porous metal layer (41) at the center side (a) and at the outer peripheral side part (b) were measured. (ii) Measurement of modulus of elasticity of center side (a) and outer peripheral side part (b)

As described in Example 1, the moduli of elasticity of the porous metal layer (42) at the center side (a) and at the outer peripheral side part (b) were measured.

### (iii) Temperature cycling test (TCT)

Temperature cycling tests were performed on ten samples in which the porous metal layer (41) was formed on the copper plate of the DBC substrate in the same way as described in Example 1.

The results of (i) to (iii) are summarized in Table 1.

### [Example 5]

### (1) Formation of porous metal layer precursors (1) and (2)

As described in the Example, 1, eleven porous metal layer precursors (1) and one porous metal layer precursor (2) were formed by arranging the molded bodies composed of the metallic fine particle dispersion solution (1) on the copper plate of the DBC substrates, and arranging the semiconductor elements (1) and (2) on the molded bodies.

### (2) Formation of porous metal layers (51) and (52)

When heating and sintering the porous metal layer precursors (1) and (2) in the sintering furnace, the porous metal layers (51) and (52) were formed by sintering with the heating and sintering conditions the same as those described for Example 1 except that a pressure of 13.0 MPa was applied from the upper side of the respective semiconductor elements, and the semiconductor elements (1) and (2) were joined to the copper plates of the DBC substrates via the respective porous metal layers.

The thickness of the porous metal layer (51) used for measuring the porosity was 102 µm.

The porous metal layers (51) and (52) were evaluated as follows.

### (3) Evaluations

### (i) Porosity measurement

### (i-1) Measurement of porosity of center side (a) and outer peripheral side part (b)

As described in Example 1, the porosities of the porous metal layer (51) at the center side (a) and at the outer peripheral side part (b) were measured. (i-2) Measurement of porosity at eight locations from the side surface toward the inside of the porous metal layer (51)

Porosity was measured at positions 3400 µm and 3500 µm from the side surface, and 350 µm from the side surface side toward the inside at a pitch of 50 µm in the cross-sectional plane of the porous metal layer (51) in the same way as described in Example 1. The results are shown in Table 2 and the results of Table 2 are plotted in FIG. 3. As illustrated in Table 2 and FIG. 3, it can be found that in the outer peripheral side part (b), the porosity increased from the position roughly equivalent to the thickness from the side surface of the porous metal layer (51) and that the porosity of the center side (a) was approximately constant.

### (ii) Measurement of modulus of elasticity of center side (a) and outer peripheral side part (b)

As described in Example 1, the moduli of elasticity of the porous metal layer (52) at the center side (a) and at the outer peripheral side part (b) were measured.

### (iii) Temperature cycling test (TCT)

Temperature cycling tests were performed on ten samples in which the porous metal layer (51) was formed on the copper plate of the DBC substrate in the same way as described in Example 1.

The results of (i) to (iii) are summarized in Table 1.

### [Example 6]

### (1) Formation of porous metal layer precursors (E1) and (E2) and formation of porous metal layers (61) and (62)

In Example 6, a total of twelve samples: one sample for measuring porosity, ten samples for temperature cycling testing, and one sample for measuring modulus of elasticity were fabricated by using a metal mask with a thickness of 350 µm and a squeegee with an opening diameter of 10 mm × 10 mm on the copper plate of the DBC substrate, and then printing the metallic fine particle dispersion solution (3).

The semiconductor element (1) was arranged on the printed part of the eleven samples to obtain the porous metal layer precursor (E1).

The semiconductor element (2) was arranged on the printed part of the one sample to obtain the porous metal layer precursor (E2).

The DBC substrates on which the precursors (E1) and (E2) were formed were arranged on the lower heating platen in the vacuum press, mold release agents (PTFE sheets) were arranged on the semiconductor elements (1) and (2) in the same way as described in Example 1, heating was started at a temperature elevation rate of 10°C/minute and after raising the temperature to 350°C, the temperature was held for 5 minutes while applying the pressure shown in Table 1 from the upper side of the semiconductor elements (1) and (2) with the upper heating platen in an air atmosphere. Next the samples were cooled and unloaded to obtain the porous metal layers (61) and (62).

### (2) Evaluations

### (i) Measurement of porosity of center side (a) and outer peripheral side part (b)

As described in Example 1, the porosities of the porous metal layer (61) at the center side (a) and at the outer peripheral side part (b) were measured.

### (ii) Measurement of modulus of elasticity of center side (a) and outer peripheral side part (b)

As described in Example 1, the moduli of elasticity of the porous metal layer (62) at the center side (a) and at the outer peripheral side part (b) were measured.

### (iii) Temperature cycling test (TCT)

Temperature cycling tests were performed on ten samples in which the porous metal layer (61) was formed on the copper plate of the DBC substrate in the same way as described in Example 1.

The results of (i) to (iii) are summarized in Table 1.

**Table 1**

| | | | Example 1 | Example 2 | Example 3 | Example 4 | Example 5 | Example 6 |
|---|---|---|---|---|---|---|---|---|
| (1) Formation of precursors | | | | | | | | |
| Method for forming precursors | | | Molded body | Molded body | Molded body | Molded body | Molded body | Printing |
| (2) Sintering conditions | | | | | | | | |
| Predrying | | | None | None | None | None | None | None |
| Pressurization during sintering | | (MPa) | 5.0 | 7.5 | 10.0 | 12.5 | 13.0 | 15.0 |
| (3) Evaluation results | | | | | | | | |
| (a) Porosity | | | | | | | | |
| Measurement location | Outer peripheral side part (b) | (%) | 22.0 | 18.4 | 17.8 | 16.6 | 16.7 | 16.7 |
| | Center side (a) | (%) | 20.0 | 15.8 | 13.5 | 11.5 | 10.7 | 11.0 |
| | Ratio (b/a) | - | 1.10 | 1.16 | 1.32 | 1.44 | 1.56 | 1.52 |
| (b) Modulus of elasticity | | | | | | | | |
| Measurement location | Outer peripheral side part (b) | (GPa) | 47.6 | 52.1 | 53.5 | 56.4 | 56.1 | 40.1 |
| | Center side (a) | (GPa) | 49.9 | 58.4 | 64.5 | 72.2 | 75.0 | 50.8 |
| | Ratio (b/a) | - | 0.95 | 0.89 | 0.83 | 0.78 | 0.75 | 0.79 |
| (c) Temperature cycle testing (TCT) | | | | | | | | |
| Reliability | | | A | A | A | B | B | B |

**Table 2**

| | | Example 1 | Example 3 | Example 5 |
|---|---|---|---|---|
| Thickness of porous metal layer (µm) | | 203 | 151 | 102 |
| | Distance from side surface | | | |
| | 50(µm) | 22.0 | 17.8 | 16.7 |
| | 100(µm) | 22.0 | 17.8 | 16.7 |
| | 150(µm) | 21.9 | 17.7 | 11.1 |
| Porosity (%) | 200(µm) | 21.9 | 13.8 | 11.1 |
| | 250(µm) | 20.1 | 13.8 | 11.0 |
| | 350(µm) | 20.0 | 13.7 | 10.8 |
| | 3400(µm) | 20.0 | 13.5 | 10.8 |
| | 3500(µm) | 20.0 | 13.5 | 10.7 |

### [Comparative Examples 1-5]

### (1) Formation of porous metal layer precursors (1) and (2), and formation of porous metal layers (C1-1 to C1-5) and (C2-1 to C2-5)

In Comparative Examples 1 to 5, the semiconductor elements (1) and (2) were used, the porous metal layer precursors (1) and (2) were formed in the same way as described in Example 1, and when heating and sintering, the samples were sintered under the same heating and sintering conditions as described in Example 1 except that the pressures were applied from the upper side of the semiconductor elements as shown in Table 3, and the semiconductor elements (1) and (2) were joined to the copper plates of the DBC substrates via the respective porous metal layers (C1-1 to C1-5) and (C2-1 to C2-5).

The obtained porous metal layers (C1-1 to C1-5) and (C2-1 to C2-5) were evaluated as described below.

### (2) Evaluations

### (i) Measurement of porosity of center side (a) and outer peripheral side part (b)

As described in Example 1, the porosities of the porous metal layer (C1-1 to C1-5) were measured at the center side (a) and at the outer peripheral side part (b).

### (ii) Measurement of modulus of elasticity of center side (a) and outer peripheral side part (b)

As described in Example 1, the moduli of elasticity of the porous metal layers (C2-1 to C2-5) were measured at the center side (a) and at the outer peripheral side part (b).

### (iii) Temperature cycling test (TCT)

Temperature cycling tests were performed on ten samples in which the porous metal layers (C1-1 to C1-5) were formed on the copper plate of the DBC substrate in the same way as described in Example 1.

The results of (i) to (iii) are summarized in Table 3.

**Table 3**

| | | | Comparative Example 1 | Comparative Example 2 | Comparative Example 3 | Comparative Example 4 | Comparative Example 5 |
|---|---|---|---|---|---|---|---|
| (1) Formation of precursors | | | Molded body | Molded body | Molded body | Molded body | Molded body |
| Method for forming precursors | | | None | None | None | None | None |
| (2) Sintering conditions | | | | | | | |
| Predrying | | | None | None | None | None | None |
| Pressurization during sintering | | (MPa) | 2.0 | 3.0 | 4.0 | 14.0 | 15.0 |
| (3) Evaluation results | | | | | | | |
| (a) Porosity | | | | | | | |
| Measurement location | Outer peripheral side part (b) | (%) | 27.0 | 23.8 | 21.9 | 16.5 | 15.9 |
| | Center side (a) | (%) | 25.7 | 22.4 | 20.4 | 10.2 | 9.6 |
| | Ratio (b/a) | - | 1.05 | 1.06 | 1.07 | 1.62 | 1.66 |
| (b) Modulus of elasticity | | | | | | | |
| Measurement location | Outer peripheral side part (b) | (GPa) | 41.5 | 43.6 | 46.1 | 55.2 | 57.8 |
| | Center side (a) | (GPa) | 42.6 | 45.4 | 48.2 | 76.4 | 79.8 |
| | Ratio (b/a) | - | 0.97 | 0.96 | 0.96 | 0.72 | 0.72 |
| (c) Temperature cycle testing (TCT) | | | | | | | |
| Reliability | | | D | D | D | C | C |

### [Comparative Examples 6-15]

### (1) Formation of porous metal layer precursors (C1) and (C2), and formation of porous metal layers (C1-6 to C1-15) and (C2-6 to C2-15)

In Comparative Examples 6 to 15, a metal mask with a thickness of 350 µm and a squeegee with an opening diameter of 10 mm × 10 mm were used to print the metallic fine particle dispersion solution (2) on the copper plate of the DBC substrate.

The porous metal layer precursors (C1) and (C2) were obtained by arranging the DBC substrates having the metallic fine particle dispersion solution (2) printed thereon in a heating furnace, predrying the substrates for 60 minutes at 100°C, and then arranging the semiconductor elements (1) and (2) on the dried printed parts.

The DBC substrates formed with the precursors were arranged on the lower heating platen of the vacuum press and mold release agents (PTFE sheets) were arranged on the semiconductor elements in the same way as described in Example 1, and then heating was started at a temperature elevation rate of 10°C/minute and after the temperature reached 300°C, the temperature was held for 20 minutes while the pressures shown in Tables 4 and 5 were applied from the upper side of the semiconductor elements (1) and (2) in a reduced pressure atmosphere (vacuum pressure of 1 kPa). Next, the samples were cooled and unloaded and the semiconductor elements (C1) and (C2) were joined to the copper plates of the DBC substrates via the respective porous metal layers (C1-6 to C1-15) and (C2-6 to C2-15). The porous metal layers (C1-6 to C1-15) and (C2-6 to C2-15) were evaluated as follows.

### (2) Evaluations

### (i) Measurement of porosity of center side (a) and outer peripheral side part (b)

As described in Example 1, the porosities of the porous metal layer (C1-6 to C1-15) at the center side (a) and at the outer peripheral side part (b) were measured.

### (ii) Measurement of modulus of elasticity of center side (a) and outer peripheral side part (b)

As described in Example 1, the moduli of elasticity of the porous metal layer (C2-6 to C2-15) at the center side (a) and at the outer peripheral side part (b) were measured.

### (iii) Temperature cycling test (TCT)

Temperature cycling tests were performed on ten samples in which the porous metal layers (C1-6 to C1-15) were formed on the copper plate of the DBC substrate in the same way as described in in which the structure in which Example 1.

The results of (i) to (iii) are summarized in Tables 4 and 5.

**Table 4**

| | | | Comparative Example 6 | Comparative Example 7 | Comparative Example 8 | Comparative Example 9 | Comparative Example 10 |
|---|---|---|---|---|---|---|---|
| (1) Formation of precursors | | | | | | | |
| Method for forming precursors | | | Printing | Printing | Printing | Printing | Printing |
| (2) Sintering conditions | | | | | | | |
| Predrying | | | 100C, 60 minutes | 100°C, 60 minutes | 100°C, 60 minutes | 100°C, 60 minutes | 100°C, 60 minutes |
| Pressurization during sintering | | (MPa) | 2.0 | 3.0 | 4.0 | 5.0 | 7.5 |
| (3) Evaluation results | | | | | | | |
| (a) Porosity | | | | | | | |
| Measurement location | Outer peripheral side part (b) | (%) | 29.0 | 24.6 | 22.4 | 20.9 | 17.1 |
| | Center side (a) | (%) | 28.6 | 23.2 | 21.1 | 19.8 | 16.2 |
| | Ratio (b/a) | - | 1.01 | 1.06 | 1.06 | 1.06 | 1.06 |
| (b) Modulus of elasticity | | | | | | | |
| Measurement location | Outer peripheral side part (b) | (GPa) | 41.2 | 43.3 | 45.4 | 47.5 | 55.2 |
| | Center side (a) | (GPa) | 42.0 | 44.5 | 47.3 | 49.4 | 57.6 |
| | Ratio (b/a) | - | 0.98 | 0.97 | 0.96 | 0.96 | 0.96 |
| (c) Temperature cycle testing (TCT) | | | | | | | |
| Reliability | | | D | D | D | C | C |

**Table 5**

| | | | Comparative Example 11 | Comparative Example 12 | Comparative Example 13 | Comparative Example 14 | Comparative Example 15 |
|---|---|---|---|---|---|---|---|
| (1) Formation of precursors | | | | | | | |
| Method for forming precursors | | | Printing | Printing | Printing | Printing | Printing |
| (2) Sintering conditions | | | | | | | |
| Predrying | | | 100°C, 60 minutes | 100°C, 60 minutes | 100°C, 60 minutes | 100°C, 60 minutes | 100°C, 60 minutes |
| Pressurization during sintering | | (MPa) | 10.0 | 12.5 | 13.0 | 14.0 | 15.0 |
| (3) Evaluation results | | | | | | | |
| (a) Porosity | | | | | | | |
| Measurement location | Outer peripheral side part (b) | (%) | 14.8 | 12.3 | 11.8 | 11.3 | 10.6 |
| | Center side (a) | (%) | 14.0 | 11.6 | 11.0 | 10.6 | 9.9 |
| | Ratio (b/a) | - | 1.06 | 1.06 | 1.07 | 1.07 | 1.07 |
| (b) Modulus of elasticity | | | | | | | |
| Measurement location | Outer peripheral side part (b) | (GPa) | 61.3 | 69.1 | 70.7 | 73.0 | 75.1 |
| | Center side (a) | (GPa) | 63.8 | 71.9 | 74.0 | 75.7 | 78.4 |
| | Ratio (b/a) | - | 0.96 | 0.96 | 0.96 | 0.96 | 0.96 |
| (c) Temperature cycle testing (TCT) | | | | | | | |
| Reliability | | | C | C | C | D | D |

### [Summary of evaluations]

Based on the results in Tables 1 to 5, it can be found that the mechanical stress and the thermal stress on the semiconductor element were absorbed and breakage of the semiconductor element was prevented and the reliability of the connection structure can be improved because the outer peripheral side part (b) of the porous metal layer (C) that joins the substrate (or lead frame) and the semiconductor element on the substrate of the connection structure of the present invention, has a higher porosity than that of the center side (a).

### [2] Examples 7 to 11 and Comparative Examples 16 to 18 of the second embodiment of the present invention

(1) The raw materials and (2) the evaluation method used in the examples and comparative examples are described below.

### (1) Raw materials

### (i) Preparation of nano copper paste

A nano copper paste was obtained by blending 80 g of copper fine particle having an average primary particle diameter of 50 nm in a dispersion medium composed of 15 g of ethylene glycol and 5 g of erythritol and then blending the paste sufficiently using a mortar.

### (ii) Substrate

A DBC substrate formed by joining copper plates with a thickness of 0.1 mm to both sides of a ceramic (AIN) plate with a thickness of 0.635 mm, was used as the substrate.

### (iii) Semiconductor element

A 7 mm × 7 mm semiconductor element with a thickness of 230 µm for thermal cycle testing evaluation, and a 3.2 mm × 3.2 mm semiconductor element with a thickness of 230 µm for shear testing evaluation were formed by metalizing the back side metallizations thereof with a Ti layer and a Ni layer in order. The surfaces opposite the back side metallization of the semiconductor elements were provided with pads for wire bonding.

### (2) Evaluation method

### (i) Measurement of porosity

The measurement of the porosity was carried out by image processing by using a scanning electron microscope (SEM) (SEMEDX Type N, manufactured by Hitachi, Ltd.) to image an area within 500 µm from the center of the cross-sectional plane of the fine copper layer and the porous copper layer of the connection structures obtained with the examples and the comparative examples cut vertically so as to be split into two pieces, with an accelerating voltage during observation of 20.0 kV, a magnification during observation of 5000 times, and a working distance (WD) of 12.1 mm, to make two types of SEM images with a secondary electron image. Image processing was carried out by using image processing software (WinROOF manufactured by Mitani Corporation), and the processing range was set at 10 µm vertical by 20 µm horizontal of the SEM image. Binary processing was implemented using binarization with two threshold values. At this time, the two concentration (brightness) threshold values were set to 0 (minimum) and 100 (maximum). The surface area ratio was selected as the measurement item. In the surface area ratio, the parts not included in the porous metal portions derived from the metallic fine particles (M) signify the porosity (%).

### (ii) Shear testing

Shear testing was performed with the following method by applying a shear force in the horizontal direction to the semiconductor element parts of the connection structure samples.

The samples for shear strength evaluations were fabricated by grinding off the porous copper layer portion protruding from the outer peripheral part of the semiconductor element on the copper plate of the DBC substrate among the connection structure samples obtained from the examples and the comparative examples. A "Universal bond tester, model: 400 series" manufactured by Dage Japan Co., Ltd. was used as the shear testing apparatus. A shear tool was set at a position 50 µm higher than the interface of the porous copper layer and the fine copper layer, and a shear tool feeding speed was set to 50 µm/second to apply a shear force in the horizontal direction from the side of the semiconductor element.

The criteria was based on failure test samples when the shear strength on an outer diameter surface area (3.2 mm × 3.2 mm) of the semiconductor element was less than 50 MPa and successful test samples when the shear strength was 50 MPa or more, to derive a ratio of the successful test samples.

### (iii) Temperature cycling test (TCT)

The connection structure samples obtained from the examples and the comparative examples were subjected to the 1000-cycle repetitive thermal cycling testing in which the samples were maintained at a temperature of -55°C for 30 minutes and then the temperature was raised to 175°C and held for 30 minutes. Defects such as internal voids, cracking, and peeling of the connection structure samples were observed by ultrasonic nondestructive visualization using a scanning acoustic tomograph (SAT) (apparatus name: mi-scope, manufactured by Hitachi Construction machinery Co., Ltd..). The defective portions and interfaces appeared white when using a reflection method with the apparatus.

The criteria was based on failure test samples when the peeling surface area was 20% or more of the joint surface area and successful test samples when the peeling surface area was less than 20% of the joint surface area, and a ratio of the successful test samples was derived.

### [Example 7]

A fine copper layer with a thickness of 2 µm was formed by coating copper on the Ni layer which was the outermost layer of the back side metallization of the semiconductor element. The nano copper paste was printed to a thickness of 350 µm on each of DBC substrates prepared for TCT evaluation and shear testing evaluation using a spacer with a 7 mm × 7 mm opening for the TCT evaluation and using a spacer with a 5 mm × 5 mm opening for the shear testing evaluation, and then the fine copper layer formed on the semiconductor element was placed on the printed nano copper paste.

Next, the obtained samples were heated and sintered and the copper fine particles included in the nano copper paste were sintered to form the porous copper layer with a thickness of 98 µm, and the semiconductor element was joined to the DBC substrate to obtain the connection structure sample of Example 7. The sintering was carried out by heating for 20 minutes at the temperature raised from an ambient temperature at a rate of 10°C/minute to reach 300°C, in a vacuum under a pressure of 10 MPa applied from the upper side of the semiconductor element. The porosity of the fine copper layer was 1% and the porosity of the porous copper layer was 15%.

### [Example 8]

The sintering was carried out in the same way as in Example 7 except that the heating involves raising the temperature from the ambient temperature at a rate of 10°C/minute to reach a temperature of 350°C and the temperature was maintained for 60 minutes in a vacuum and under a pressure of 20 MPa to obtain the connection structure samples according to Example 8. The porosity of the fine copper layer was 1% and the porosity of the porous copper layer was 2%.

### [Example 9]

The connection structure sample of Example 9 was obtained in the same way as in Example 7 except that the thickness of the fine copper layer was 10 µm and the thickness of the porous copper layer was 90 µm.

### [Example 10]

The connection structure sample of Example 10 was obtained in the same way as in Example 7 except that the thickness of the fine copper layer was 11 µm and the thickness of the porous copper layer was 98 µm.

### [Example 11]

The connection structure sample of Example 11 was obtained in the same way as in Example 7 except that the thickness of the fine copper layer was 0.1 µm and the thickness of the porous copper layer was 98 µm.

### [Comparative Example 16]

The connection structure sample of the Comparative Example 16 was obtained in the same way as the Example 7 except that the porosity of the porous copper layer was 15%.

### [Comparative Example 17]

The connection structure sample of the Comparative Example 17 was obtained in the same way as the Example 7 except that the porosity of the fine copper layer was 5%.

### [Comparative Example 18]

The connection structure sample of the Comparative Example 18 was obtained in the same way as the Example 7 except that the sintering was carried out under the conditions of raising the temperature from an ambient temperature at a rate of 10°C/minute to reach 300°C and the temperature was maintained for 20 minutes in a vacuum and with a pressure of 5 MPa. The porosity of the porous copper layer was 20%.

The results obtained from Examples 7 to 11 and Comparative Examples 16 to 18 are summarized in Table 6.

**Table 6**

| | | Example 7 | Example 8 | Example 9 | Example 10 | Example 11 | Comparative Example 16 | Comparative Example 17 | Comparative Example 18 |
|---|---|---|---|---|---|---|---|---|---|
| (1) Eine copper layer | | | | | | | | | |
| Porosity of copper layer | (%) | 1 | 1 | 1 | 1 | 1 | - | 5 | 1 |
| Thickness of copper layer | (µm) | 2 | 2 | 10 | 11 | 0.1 | 0 | 2 | 2 |
| (2) Porous copper layer | | | | | | | | | |
| Porosity of copper layer | (%) | 15 | 2 | 15 | 15 | 15 | 15 | 15 | 20 |
| Thickness of copper layer | (µm) | 98 | 98 | 90 | 98 | 98 | 100 | 98 | 98 |
| (3) Shear testing | | | | | | | | | |
| Number of test samples | (units) | 10 | 10 | 10 | 10 | 10 | 10 | 10 | 10 |
| Number of successful test samples | (units) | 10 | 10 | 10 | 10 | 10 | 10 | 10 | 6 |
| (4) TCT testing | | | | | | | | | |
| Number of test samles | (units) | 15 | 15 | 15 | 15 | 15 | 15 | 15 | 15 |
| Number of successful test samples | (units) | 15 | 14 | 14 | 13 | 13 | 10 | 11 | 15 |
| (5) Success rate of testing | | | | | | | | | |
| Success rate shear testing | (%) | 100.0 | 100.0 | 100.0 | 100.0 | 100.0 | 100.0 | 100.0 | 60.0 |
| Success rate TCT testing | (%) | 100.0 | 93.3 | 93.3 | 86.7 | 86.7 | 66.7 | 73.3 | 100.0 |

### [Summary of evaluations]

In the Examples 7 to 11, favorable results for shear testing and TCT were obtained because the connection structure samples have the porous copper layer (D2) with a porosity of 2% to 15% and the fine copper layer (D1) with a porosity of 1% or less. Conversely, the TCT result of the Comparative Example 16 was poor because, although the porosity of the porous copper layer was from 2% to 15%, localized stress was concentrated on the interface because the fine copper layer was not present. The TCT result of the Comparative Example 17 was poor because localized stress was concentrated on the interface because the porosity of the fine copper layer was high at 5% and pin holes were present in the fine copper layer. The shear testing result of the Comparative Example 18 was poor because the porosity of the porous copper layer was high at 20%.

According to the connection structure of the third embodiment as described above, because the porosity of the porous copper layer (D2) is from 2% to 15% or more, it has been found that the surface area for joining the metal at the connection interfaces is increased, the breaking strength and the elongation at high temperatures of the porous copper layer (D2) is increased, and the connection strength between the copper fine particles in the porous copper layer (D2) and of the connection interface with the porous copper layer (D2) is improved. Moreover, it has been found that the apparent modulus of elasticity is lowered, stress applied to the semiconductor element can be alleviated, and the occurrence of cracking of the semiconductor element can be prevented due to the porous copper layer (D2) having vacancies.

Furthermore, it has been found that when the fine copper layer (D1) having a porosity of 1% or less is formed so as to come into contact with the back side metallization of the semiconductor element, localized stress generated in the semiconductor element and in the joint interface can be alleviated and the long-term reliability can be improved.

### Reference Number

- 11:: Workpiece
- 12:: Press plate
- 13:: Vacuum press
- 14:: Lower heating platen
- 15:: Chamber
- 16:: Pressurizing cylinder
- 17:: Upper heating platen
- 20:: Connection structure
- 22:: Semiconductor element
- 23:: Back side metallization
- 24:: Substrate
- 25:: Pad
- 26:: Porous copper layer
- 27:: Fine copper layer

## Claims

1. A connection structure (I) for connecting a back side metallization of a semiconductor element to a substrate or a lead frame,
a porous metal layer (C) being provided so as to come into contact with at least the back side metallization of the semiconductor element, and a ratio [(B)/(A)] of a porosity of an intermediate portion in the thickness direction of an outer peripheral side part (B) of a region further towards the outside than the cross-section part formed at a position of a distance equivalent to the thickness of the porous metal layer (C) from the side surface of the porous metal layer (C) toward the inside, to the porosity on the center side (A) after having excluded the outer peripheral side part (B), falling within the range of 1.10 to 1.60.

2. The connection structure according to claim 1, wherein the porosity of the center side (A) is from 10.5% to 20.0% in the porous metal layer (C).

3. The connection structure according to claim 1 or 2, wherein a ratio [(B)/(A)] of the modulus of elasticity of a joint layer of semiconductor elements of the outer peripheral side part (B) to the modulus of elasticity of a joint layer of semiconductor elements on the center side (A) is from 0.75 to 0.95 in the porous metal layer (C).

4. The connection structure according to any one of claims 1 to 3, wherein the modulus of elasticity of the joint layer with semiconductor elements of the center side (A) is from 49.0 GPa to 75.0 GPa in the porous metal layer (C).

5. The connection structure according to any one of claims 1 to 4, wherein the porous metal layer (C) is a layer formed by sintering a metallic fine particle dispersion material (E1) in which metallic fine particles including metallic fine particles (M1) having an average particle diameter of 1 nm to 500 nm are dispersed in an organic dispersion medium (S).

6. The connection structure according to claim 5, wherein the metallic fine particles (M) are one or two or more metals selected from copper, gold, silver, nickel, and cobalt.

7. The connection structure according to any one of claims 1 to 6, wherein a heat resistant resin (R) fills at least a portion inside the porous metal layer of the outer peripheral side part (B) in the porous metal layer (C).

8. A semiconductor apparatus comprising the connection structure (I) described in any one of claims 1 to 7.

9. A connection structure (II) for connecting a back side metallization of a semiconductor element to a substrate or a lead frame,
a fine copper layer (D1) and a porous copper layer (D2) being provided in order so as to come into contact with at least the back side metallization of the semiconductor element, and
porosity of the fine copper layer (D1) being 1% or less and porosity of the porous copper layer (D2) being from 2% to 15%.

10. The connection structure according to claim 9, wherein thickness of the fine copper layer (D1) is from 0.1 µm to 10 µm.

11. The connection structure according to claim 9 or 10, wherein a heat resistant resin (R) fills at least a portion of the porous copper layer (D2).

12. The connection structure according to any one of claims 9 to 11, wherein the porous copper layer (D2) is a layer formed by sintering a copper fine particle dispersion material (E2) in which copper fine particles (P) are dispersed in a dispersion medium, and an average primary particle diameter of the copper fine particles (P) in the copper fine particle dispersion material (E2) is from 1 nm to 500 nm.

13. The connection structure according to any one of claims 9 to 12, wherein the back side metallization of the semiconductor element is a Ni layer coated with Ni or a Ni alloy.

14. A semiconductor apparatus comprising the connection structure (II) described in any one of claims 9 to 13.
